# EUROPEAN PATENT SPECIFICATION

(11) **EP 1 932 802 B1**
(45) Date of publication and mention of the grant of the patent: **03.07.2013**
(21) Application number: 06125831.5
(22) Date of filing: 11.12.2006
(51) Int. Cl.: B67D 7/84

(54) **Fuel dispenser housing with cable passage**
Kraftstoffzapfanlagengehäuse mit Kabelkanal
Carter d'une pompe à essence avec gaine pour câbles

(43) Date of publication of application: 18.06.2008
(73) Proprietor: Dresser Wayne AB, 202 15 Malmö (SE)
(72) Inventor: Larsson, Bengt I., 274 53 Skivarp (SE); Petersen, Kenneth, 216 20 Malmö (SE)
(74) Representative: Milanov, Nina Vendela Maria

(56) References cited:
- EP-A- 1 333 007
- US-A- 4 461 401

## Description

### Technical Field

The present invention relates to a fuel dispensing unit and the arrangement of an electrical cable within the fuel dispensing unit, and a method of drawing a cable when assembling a fuel dispensing unit.

### Background Art

Today fuel dispensing units are arranged at petrol stations for filling fuel in various vehicles. A typical fuel dispensing unit has a lower compartment which is arranged on the ground and houses a pump for drawing fuel from an underground fuel storage. The pump feeds the fuel to a fuel meter and eventually to a flexible fuel hose fitted with a fuel dispensing nozzle that is inserted, by a user, in a vehicle tank.

The amount of fuel dispensed at the fuel dispensing nozzle is measured by the fuel meter which sends a signal representative of the amount to an electronics compartment. The electronics compartment calculates the cost of the dispensed fuel and presents the information for the user. Often the electronics compartment also has a payment terminal for increasing the level of self-service. The electronics compartment is usually arranged above the fuel handling compartment, either directly on top of the lower fuel handling compartment or attached to a column that extends vertically from the ground.

Explosive fuel vapour may be present in the lower fuel handling compartment and, if the fuel dispensing unit has a column, in or near the column. The electronics compartment commonly incorporates electronic components having voltages and electrical current levels that are above an admissible level in terms of the risk of explosion, and therefore the electronics compartment is separated from the lower fuel handling compartment, either by a specific distance or by suitable barriers.

To facilitate communication between the fuel handling compartment and the electronics compartment, various electrical cables are drawn from the lower fuel handling compartment to the upper electronics compartment. These cables have different passageways and are often bundled together at some point during assembly or maintenance of the fuel dispensing unit. Bundling and drawing of cables is often time consuming and cumbersome, and therefore increase production and operation costs of the fuel dispensing unit. Another problem with prior art is that fuel vapour may flow from a space were the cable is arranged to another space were electronic components are arranged, which introduces a risk of explosion.

US-4, 461, 401 discloses an upright tubular housing which is divided into a lower compartment, a central. compartment and an upper compartment by horizontal partition plates. Within the lower compartment are the hydraulic components which may be any number of a variety of hydraulic systems from conventional non-electronic or electronic gasoline pumps. A meter of the hydraulic system drives a shaft which, in turn, drives a pulser disposed in the intermediate compartment to provide a clock pulse. Within the upper compartment are the electronic components which include the power supply and a number of pc boards or cards, including a computer board carrying a microprocessing unit, a power fail detector, and a non-volatile memory.

### Summary of the invention

It is an object of the present invention to provide an improvement of the above techniques and prior art, which is achieved by a fuel dispensing unit that comprises an electronics compartment having a channel for separating a cable from the electronics compartment.

Other objects and advantages that will be apparent from the following description of the present invention are achieved by a fuel dispensing unit and method according to the respective independent claims. Preferred embodiments are defined in the dependent claims.

Accordingly, a fuel dispensing unit is provided, comprising a fuel handling compartment and an electronics compartment having a first lower side facing the fuel handling compartment, said electronics compartment being connected to the fuel handling compartment via at least one electrical cable. The electronics compartment comprises a sub-compartment for electrical components, and a horizontal channel which extends along the first lower side of the electronic compartment and in which at least a part of said at least one cable is provided, for separating said at least one cable from the sub-compartment. The lower part of the horizontal channel is covered by at least one perforated plate member.

The inventive fuel dispensing unit is advantageous in that the cable is easily drawn through or past the electronics compartment, time consuming work of bundling and attaching cables is reduced, efficient assembly of the fuel dispensing unit is facilitated and convenient cable maintenance is provided. Another advantage is that the channel provides a barrier for fuel vapour, which reduces a risk of explosion.

The electronics compartment may be connected to the fuel handling compartment via at least two electrical cables, said channel having a divider for separating the at least two cables. This is advantageous in that a cable that is sensitive for electrical interference may be separated from an interfering one.

The channel may extend along a second side of the electronics compartment, for providing convenient drawing and easy access to the cable.

The channel may comprise a cable entry into the sub-compartment for electrical components, and the cable entry may be arranged in the channel extending along the second side of the electronics compartment. This is advantageous in that the cable is readily connected to electrical components in the sub-compartment of the electronics compartment.

The channel may be formed by steel plates, which provides low material and production costs.

A third side of the electronics compartment may face a column of the fuel dispensing unit, which offers convenient mounting of the electronics compartment to the fuel dispensing unit.

The third side of the electronics compartment may be opposite the second side of the electronics compartment, and the channel may extend from the third side of the electronics compartment to the second side of the electronics compartment. This further facilitates convenient drawing of the cable.

The electronics compartment may comprise an upper part defining an upper sub-compartment and a lower part defining a lower sub-compartment, the lower part being separated from the upper part by a separating plate member. This provides easy re-fitting of different parts of the electronics compartment.

The separating plate member may comprise vent openings, for preventing the risk of flammable vapour accumulating within the upper part of the electronics compartment.

A common plate may cover at least a part of a second side of both the upper part and the lower part of the electronics compartment, which further decreases the assembly cost.

According to another aspect of the invention, a method of assembling a fuel dispensing unit is provided, said method comprising the steps of: mounting an electronics compartment having a first lower side facing the fuel handling compartment to the fuel dispensing unit, and drawing an electrical cable, from the fuel handling compartment of the fuel dispensing unit, through a horizontal channel which extends along the first lower side of the electronics compartment, said horizontal channel separating at least a part of the cable from a sub-compartment of the electronics compartment, and covering the lower part of the horizontal channel with at least one perforated plate member.

It should be noted that the inventive method may incorporate any of the features described above in connection with the inventive fuel dispensing unit, and have the same respective advantages.

### Brief Description of the Drawings

Embodiments of the present invention will now be described, by way of example, with reference to the accompanying schematic drawings, in which
Fig. 1 is a side view of a fuel dispensing unit according to the invention,
Fig. 2 is a perspective view of an electronics compartment of the fuel dispensing unit in Fig. 1,

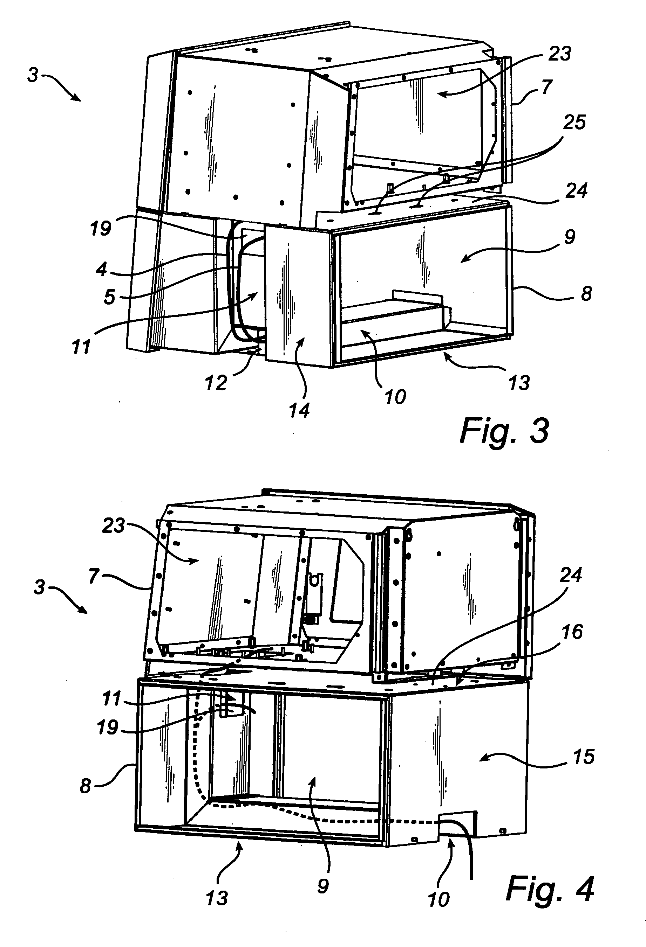

Fig. 3 is a perspective view of a second side of the electronics compartment in Fig. 2, with external panels removed, and
Fig. 4 is a perspective view of a third side of the electronics compartment in Fig. 2, with external panels removed.

### Detailed Description of Preferred Embodiments of the Invention

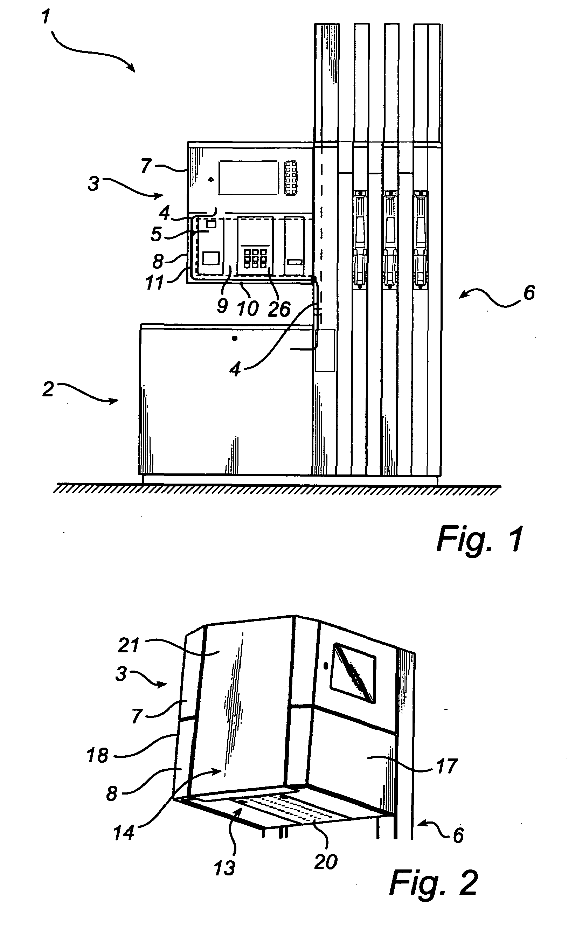

Fig. 1 illustrates a fuel dispensing unit 1 that has a lower fuel handling compartment 2 and an upper electronics compartment 3 arranged above the fuel handling compartment 2. A column 6 is connected to the fuel handling compartment 2, supports the electronics compartment 3 and incorporates flexible fuel hoses (not shown) fitted with a respective fuel dispensing nozzle.

The third side 15 of the electronics compartment 3 is proximate and attached to the column 6, and the first side 13 of the electronics compartment is facing the fuel handling compartment 2 and is preferably arranged at a distance from the fuel handling compartment 2.

In a preferred embodiment the electronics compartment 3 has lower part 8 formed by said six sides 13-18 that defines the previously mentioned sub-compartment 9, and an upper part 7 that defines an upper sub-compartment 23. The lower part 8 is separated from the upper part 7 by a separating plate member 24, which is advantageous in that different electrical modules may be separately mounted in the electronics compartment 3. For example, the upper part 7 comprises a control unit (not shown) for the fuel dispenser and the lower part 8 comprises the payment terminal 26. The separating plate member 24 has a plurality of vent openings 25 in the form of through holes for allowing any fuel vapour in the upper sub-compartment 23 to flow in a downward direction, out from the upper sub-compartment 23.

The electronics compartment 3, or, in the illustrated embodiment, the lower part 8 of the electronics compartment, comprises a substantially horizontal channel 10 in the first side 13, and the channel 10 extends the full length of the first side 13, from the third 15 to the second side 14 of the electronics compartment 3. The channel further extends upward along the second side 14 of the electronics compartment 3 and thereby forms a substantially vertical channel 11 that is connected to the horizontal channel 10. The upper part of the vertical channel 11 has a cable entry 19 into the sub-compartment 9.

In the preferred embodiment a first cable 4 runs from the fuel handling compartment 2, through the column 6, through the horizontal part of the channel 10, through the vertical part of the channel 11, through an opening of the upper part 7 and into the sub-compartment 23 of the upper part 7 of the electronics compartment 3. A second cable 5 runs from the fuel handling compartment 2, through the column 6, through the horizontal part of the channel 10, through the vertical part of the channel 11, through the cable entry 19 and into the sub-compartment 9 of the lower part 8 of the electronics compartment 3.

Since the channels 10 and 11 are elongated, any vapour entering the channel 10 adjacent the column 6 would have to travel a rather long distance before entering any of the sub-compartments 9 and 23 of the electronics compartment 3, which reduces a risk of explosion. As mentioned, the sides 13-18 of the electronics compartment 3 substantially form a box-shaped structure, and the box shaped structure forms, apart from the cable entry 19, a substantially vapour tight, sealed structure.

The horizontal part of the channel 10 has a divider 12 for separating the first cable 4 from the second cable 5. The divider 12 runs in the middle of and extends the full length of the horizontal part of the channel 10. Of course, the vertical part of the channel 11 may also have a corresponding divider.

An outer plate member 21 extends the full height of the second side 14 of the electronics compartment 3 and covers the vertical part of the channel 11, while a lower, partly perforated plate member 20 extends along and covers the lower part of the horizontal part of the channel 10. The perforations in the plate member 20 allow any vapour to escape from the horizontal part of the channel 10.

The electronics compartment 3, the channels 10 and 11, and the divider 12 are preferably made of sheet steel. This, of course, means that all six sides 13-18 of the electronics compartment are made of steel sheets of various shapes. The fuel handling part 2 and all its interior components, the column 6 and the electronics in the electronics compartment 3 are arranged and cooperate in a conventional manner.

It should be noted that the horizontal part of the channel 10 is preferably sealed off from the lower sub-compartment 9, and that the third side 15 of the electronics compartment has a cutout for the horizontal part of the channel 10.

## Claims

1. A fuel dispensing unit comprising a fuel handling compartment (2) and an electronics compartment (3) having a first side (13) facing the fuel handling compartment (2), said electronics compartment (3) being connected to the fuel handling compartment (2) via at least one electrical cable (4; 5), the electronics compartment (3) comprising a sub-compartment (9) for electrical components, and a channel (10; 11) in which at least a part of said at least one cable (4; 5) is provided, for separating said at least one cable (4; 5) from the sub-compartment (9), **characterised in that** a horizontal part (10) of the channel (10; 11) extends along said first side (13) and is covered by at least one partly perforated plate member (20) at a lower part thereof.

2. A fuel dispensing unit according to claim 1, wherein the electronics compartment (3) is connected to the fuel handling compartment (2) via at least two electrical cables (4, 5), said channel (10; 11) having a divider (12) for separating the at least two cables (4, 5).

3. A fuel dispensing unit according to any one of claims 1 or 2, wherein the channel (11) extends along a second side (14) of the electronics compartment (3).

4. A fuel dispensing unit according to any one of claims 1-3, wherein the channel (10; 11) comprises a cable entry (19) into the sub-compartment (9) for electrical components.

5. A fuel dispensing unit according to claim 3 and 4, wherein the cable entry (19) is arranged in the channel (11) extending along the second side (14) of the electronics compartment (3).

6. A fuel dispensing unit according to any one of claims 1-5, wherein the channel (10; 11) is formed by steel plates.

7. A fuel dispensing unit according to any one of claims 1-6, wherein a third side (15) of the electronics compartment (3) faces a column (6) of the fuel dispensing unit (1).

8. A fuel dispensing unit according to claim 3 and 7, wherein the third side (15) of the electronics compartment (3) is opposite the second side (14) of the electronics compartment (3).

9. A fuel dispensing unit according to claim 8, wherein the channel (10) extends from the third side (15) of the electronics compartment (3) to the second side (14) of the electronics compartment (3).

10. A fuel dispensing unit according to any one of claims 1-9, wherein the electronics compartment (3) comprises an upper part (7) defining an upper sub-compartment (23) and a lower part (8) defining a lower sub-compartment (9), the lower part (8) being separated from the upper part (7) by a separating plate member (24).

11. A fuel dispensing unit according claim 10, wherein the separating plate member (24) comprises vent openings (25).

12. A fuel dispensing unit according to any one of claims 10-11, wherein a common plate (21) covers at least a part of a second side (14) of both the upper part (7) and the lower part (8) of the electronics compartment (3).

13. A method of assembling a fuel dispensing unit (1), said method comprising the steps of:
mounting an electronics compartment (3) having a first side (13) facing the fuel handling compartment (2) to the fuel dispensing unit (1),
drawing an electrical cable (4; 5), from the fuel handling compartment (2) of the fuel dispensing unit (1), through a channel (10; 11), said channel (10; 11) separating at least a part of the cable (4; 5) from a sub-compartment (9) of the electronics compartment (3), and
covering a horizontal part (10) of the channel (10; 11) extending along said first side (13) with at least one partly perforated plate member (20) at a lower part thereof.

## Patentansprüche

1. Kraftstoff-Abgabeeinheit, die eine Kraftstoff-Handhabungsabteilung (2) und eine Elektronikabteilung (3), die eine erste Seite (13) hat, die zu der Kraftstoff-Handhabungsabteilung (2) zeigt, umfasst, wobei die Elektronikabteilung (3) über wenigstens ein elektrisches Kabel (4; 5) mit der Kraftstoff-Handhabungsabteilung (2) verbunden ist, wobei die Elektronikabteilung (3) eine Unterabteilung (9) für elektrische Bauteile und einen Kanal (10; 11), in dem wenigstens ein Teil des wenigstens einen Kabels (4; 5) bereitgestellt wird, um das wenigstens eine Kabel (4; 5) von der Unterabteilung (9) zu trennen, umfasst, **dadurch gekennzeichnet, dass** sich ein horizontaler Teil (10) des Kanals (10; 11) entlang der ersten Seite (13) erstreckt und durch wenigstens ein teilweise perforiertes Plattenelement (20) an einem unteren Teil desselben abgedeckt ist.

2. Kraftstoff-Abgabeeinheit nach Anspruch 1, wobei die Elektronikabteilung (3) über wenigstens zwei elektrische Kabel (4, 5) mit der Kraftstoff-Handhabungsabteilung (2) verbunden ist, wobei der Kanal (10; 11) einen Teiler (12) hat, um die wenigstens zwei Kabel (4, 5) zu trennen.

3. Kraftstoff-Abgabeeinheit nach einem der Ansprüche 1 oder 2, wobei sich der Kanal (11) entlang einer zweiten Seite (14) der Elektronikabteilung (3) erstreckt.

4. Kraftstoff-Abgabeeinheit nach einem der Ansprüche 1 bis 3, wobei der Kanal (10; 11) einen Kabeleingang (19) in die Unterabteilung (9) für elektrische Bauteile umfasst.

5. Kraftstoff-Abgabeeinheit nach Anspruch 3 und 4, wobei der Kabeleingang (19) in dem Kanal (11) angeordnet ist, der sich entlang der zweiten Seite (14) der Elektronikabteilung (3) erstreckt.

6. Kraftstoff-Abgabeeinheit nach einem der Ansprüche 1 bis 5, wobei der Kanal (10; 11) durch Stahlplatten gebildet wird.

7. Kraftstoff-Abgabeeinheit nach einem der Ansprüche 1 bis 6, wobei eine dritte Seite (15) der Elektronikabteilung (3) zu einer Säule (6) der Kraftstoff-Abgabeeinheit (1) zeigt.

8. Kraftstoff-Abgabeeinheit nach Anspruch 3 und 7, wobei die dritte Seite (15) der Elektronikabteilung (3) der zweiten Seite (14) der Elektronikabteilung (3) gegenüberliegt.

9. Kraftstoff-Abgabeeinheit nach Anspruch 8, wobei sich der Kanal (10) von der dritten Seite (15) der Elektronikabteilung (3) zu der zweiten Seite (14) der Elektronikabteilung (3) erstreckt.

10. Kraftstoff-Abgabeeinheit nach einem der Ansprüche 1 bis 9, wobei die Elektronikabteilung (3) einen oberen Teil (7), der eine obere Unterabteilung (23) definiert, und einen unteren Teil (8), der eine untere Unterabteilung (9) definiert, umfasst, wobei der untere Teil (8) durch ein trennendes Plattenelement (24) von dem oberen Teil (7) getrennt ist.

11. Kraftstoff-Abgabeeinheit nach Anspruch 10, wobei das trennende Plattenelement (24) Lüftungsöffnungen (25) umfasst.

12. Kraftstoff-Abgabeeinheit nach einem der Ansprüche 10 bis 11, wobei eine gemeinsame Platte (21) wenigstens einen Teil einer zweiten Seite (14) sowohl des oberen Teils (7) als auch des unteren Teils (8) der Elektronikabteilung (3) abdeckt.

13. Verfahren zum Zusammenbauen einer Kraftstoff-Abgabeeinheit (1), wobei das Verfahren die folgenden Schritte umfasst:
das Anbringen einer Elektronikabteilung (3), die eine erste Seite (13) hat, die zu der Kraftstoff-Handhabungsabteilung (2) zeigt, an der Kraftstoff-Abgabeeinheit (1),
das Ziehen eines elektrischen Kabels (4; 5) von der Kraftstoff-Handhabungsabteilung (2) der Kraftstoff-Abgabeeinheit (1) durch einen Kanal (10; 11), wobei der Kanal (10; 11) wenigstens einen Teil des Kabels (4; 5) von einer Unterabteilung (9) der Elektronikabteilung (3) trennt, und
das Abdecken eines horizontalen Teils (10) des Kanals (10; 11), der sich entlang der ersten Seite (13) erstreckt, mit wenigstens einem teilweise perforierten Plattenelement (20) an einem unteren Teil desselben.

## Revendications

1. Unité de distribution de combustible comprenant un compartiment de manutention du combustible (2) et un compartiment électronique (3) ayant un premier côté (13) faisant face au compartiment de manutention du combustible (2), ledit compartiment électronique (3) étant relié au compartiment de manutention (2), par au moins un câble électrique (4; 5), le compartiment électronique (3) comprenant un sous-compartiment (9) pour des composants électriques, et un canal (10; 11) dans lequel au moins une partie dudit au moins un câble (4; 5) est prévue, pour séparer ledit au moins un câble (4; 5) du sous-compartiment (9), **caractérisé en ce qu'**une partie horizontale (10) du canal (10; 11) se prolonge le long dudit premier côté (13) et est couverte par au moins un élément de plaque partiellement perforé (20) sur une partie inférieure de celui-ci.

2. Unité de distribution de combustible selon la revendication 1, où le compartiment électronique (3) est relié au compartiment de manutention du combustible (2) par au moins deux câbles électriques (4, 5), ledit canal (10; 11) ayant un séparateur (12) pour séparer les au moins deux câbles (4, 5).

3. Unité de distribution de combustible selon l'une quelconque des revendications 1 ou 2, où le canal (11) se prolonge le long d'un deuxième côté (14) du compartiment électronique (3).

4. Unité de distribution de combustible selon l'une quelconque des revendications 1-3, où le canal (10; 11) comprend une entrée de câble (19) dans le sous-compartiment (9) pour les composants électriques.

5. Unité de distribution de combustible selon les revendications 3 et 4, où l'entrée de câble (19) est placée dans le canal (11) se prolongeant le long du deuxième côté (14) du compartiment électronique (3).

6. Unité de distribution de combustible selon l'une quelconque des revendications 1-5, où le canal (10; 11) est formé de plaques en acier.

7. Unité de distribution de combustible selon l'une quelconque des revendications 1-6, où un troisième côté (15) du compartiment électronique (3) fait face à une colonne (6) de l'unité de distribution de combustible (1).

8. Unité de distribution de combustible selon les revendications 3 et 7, où le troisième côté (15) du compartiment électronique (3) fait face au deuxième côté (14) du compartiment électronique (3).

9. Unité de distribution de combustible selon la revendication 8, où le canal (10) se prolonge depuis le troisième côté (15) du compartiment électronique (3) vers le deuxième côté (14) du compartiment électronique (3).

10. Unité de distribution de combustible selon l'une quelconque des revendications 1-9, où le compartiment électronique (3) comprend une partie supérieure (7) définissant un sous-compartiment supérieur (23) et une partie inférieure (8) définissant un sous-compartiment inférieur (9), la partie inférieure (8) étant séparée de la partie supérieure (7) par un élément de plaque de séparation (24).

11. Unité de distribution de combustible selon la revendication 10, où l'élément de plaque de séparation (24) comprend des ouvertures d'évent (25).

12. Unité de distribution de combustible selon l'une quelconque des revendications 10-11, où une plaque commune (21) couvre au moins une partie du deuxième côté (14) d'à la fois la partie supérieure (7) et la partie inférieure (8) du compartiment électronique (3).

13. Procédé d'assemblage d'une unité de distribution de combustible (1), ledit procédé comprenant les étapes de :
monter un compartiment électronique (3) ayant un premier côté (13) mettant face à face le compartiment de manutention du combustible (2) avec l'unité de distribution de combustible (1),
tirer un câble électrique (4; 5) depuis le compartiment de manutention du combustible (2) de l'unité de distribution de combustible (1), par un canal (10; 11), ledit canal (10; 11) séparant au moins une partie du câble (4; 5) d'un sous-compartiment (9) du compartiment électronique (3), et
couvrant une partie horizontale (10) du canal (10; 11) se prolongeant le long dudit premier côté (13) avec au moins un élément de plaque partiellement perforée (20) sur une partie inférieure de celui-ci.
